# EUROPÄISCHE PATENTSCHRIFT

(11) **EP 2 263 292 B1**
(45) Veröffentlichungstag und Bekanntmachung des Hinweises auf die Patenterteilung: **06.12.2017**
(21) Anmeldenummer: 09728724.7
(22) Anmeldetag: 01.04.2009
(51) Int. Cl.: H05B 41/02, H05K 5/02

(54) **ZUGENTLASTUNGSVORRICHTUNG**
APPARATUS FOR STRAIN RELIEF
DISPOSITIF DE DÉCHARGE DE TRACTION

(30) Priorität: 01.04.2008 DE 102008016605; 13.10.2008 DE 102008051482
(43) Veröffentlichungstag der Anmeldung: 22.12.2010
(73) Patentinhaber: Zumtobel Lighting GmbH, 6850 Dornbirn (AT)
(72) Erfinder: FEUERSTEIN, Anton, A-6850 Dornbirn (AT); ERHARD, Manuel, A-6714 Nüziders (AT)
(74) Vertreter: Thun, Clemens
(86) Internationale Anmeldenummer: PCT/EP2009/002386
(87) Internationale Veröffentlichungsnummer: WO 2009/121588

(56) Entgegenhaltungen:
- DE-A1- 4 300 521
- US-A- 3 634 608
- US-A1- 2005 167 147

## Beschreibung

Gegenstand der vorliegenden Erfindung ist eine Anordnung aus einem elektronischen Gerät und einer mit dem elektronischen Gerät gekoppelten Zugentlastungs-Vorrichtung zur Zugentlastung von an dem elektronischen Gerät angeschlossenen Kabeln, wobei die Zugentlastungs-Vorrichtung Mittel zur Aufnahme und klemmenden Halterung mindestens eines Kabels aufweist.

Eine bekannte Zugentlastungs-Vorrichtung zur Zugentlastung von Kabeln, die an ein elektronisches Vorschaltgerät (EVG) einer Leuchte angeschlossen werden, wird beispielsweise von der Firma Osram vertrieben. Auch aus der DE 43 00 521 A1 und der US 2005/167147 A1 sind Zugentlastungs-Vorrichtung bekannt.

Bei der Vorrichtung der Firma Osram handelt es sich um ein schalenförmiges Aufnahmeteil, in die das EVG eingelegt wird. An den beiden stirnseitigen Enden weist diese Zugentlastungs-Vorrichtung jeweils Elemente zum Einklemmen der Kabel auf. Ferner befinden sich an den Stirnseiten des Aufnahmeteils Zugentlastungselemente, mit deren Hilfe Leitungen und Kabel fixiert werden können.

Da das EVG in das Aufnahmeteil eingelegt wird, müssen die Dimensionen des EVGs und der Zugentlastungs-Vorrichtung exakt aufeinander abgestimmt werden. Dementsprechend muss für jede einzelne EVG-Größe eine speziell entsprechend ausgestaltete Zugentlastungs-Vorrichtung zur Verfügung gestellt werden.

In der US 3,634,608 wird nun eine Zugentlastungs-Vorrichtung gezeigt, die derart ausgestaltet ist, dass nicht mehr für jede einzelne EVG-Größe eine speziell entsprechend ausgestaltete Zugentlastungs-Vorrichtung zur Verfügung gestellt werden muss.

Das EVG muss nun in bestimmten Montagesituationen derart ausgestaltet sein, dass das Gehäuse nicht versehentlich geöffnet werden kann. Die Zugentlastungs-Vorrichtung in der US 3,634,608 ist jedoch nunmehr derart ausgestaltet, dass sie ein versehentliches Öffnen nicht verhindern kann.

Aufgabe der vorliegenden Erfindung ist es dementsprechend, eine Anordnung bereitzustellen, die eine Zugentlastung von an einem elektronischen Gerät angeschlossenen Kabeln unabhängig von der Größe dieses Geräts ermöglicht und ein versehentliches Öffnen des Gehäuses des elektronischen Geräts verhindert.

Diese Aufgabe wird durch eine Anordnung entsprechend dem Anspruch 1 gelöst. Vorteilhafte Weiterbildungen sind Gegenstand der Unteransprüche.

Erfindungsgemäß wird dementsprechend eine Anordnung bestehend aus einem elektronischen Gerät sowie mindestens einer mit dem elektronischen Gerät gekoppelten Zugentlastungs-Vorrichtung zur Zugentlastung von an dem elektronischen Gerät angeschlossenen Kabeln vorgeschlagen, wobei die Zugentlastungs-Vorrichtung Mittel zur Aufnahme und klemmenden Halterung mindestens eines Kabels aufweist und ferner dazu ausgebildet ist, lösbar mit einer Stirnseite des Gehäuses des elektronischen Geräts gekoppelt zu werden. Das Gehäuse des elektronischen Geräts besteht hierbei aus zumindest zwei miteinander zu verbindenden Gehäuseteilen, wobei die Zugentlastungs-Vorrichtung im an dem elektronischen Gerät befestigten Zustand die beiden Gehäuseteile aneinander arretiert.

Hierdurch bewirkt die Zugentlastungs-Vorrichtung eine Verriegelung zweier Gehäusekomponenten des elektronischen Geräts, wodurch diese nicht mehr voneinander gelöst werden können. Erst nach Entfernen der Zugentlastungs-Vorrichtung, was vorzugsweise lediglich mit Hilfe eines Werkzeugs, insbesondere eines Schraubenziehers ermöglicht ist, kann das Gehäuse dann geöffnet werden.

Vorzugsweise sind an der Zugentlastungs-Vorrichtung Vorsprünge bzw. Rastelemente und/oder Ausnehmungen vorgesehen sind, welche zum Eingreifen in entsprechende Ausnehmungen an dem Gehäuse des elektronischen Geräts bzw. zum formschlüssigen Verbinden mit Vorsprüngen des Gehäuses ausgebildet sind.

In einem bevorzugten Ausführungsbeispiel besteht die Vorrichtung aus einem Basisteil und einem Deckel, welche das mindestens eine Kabel klemmend fixieren, wobei der Deckel ferner mit dem Basisteil in einer Klemmstellung arretierbar, insbesondere verschraubbar ist. In diesem Fall ist der Deckel vorzugsweise schwenkbar mit dem Basisteil verbunden.

Nachfolgend soll die Erfindung anhand der beiliegenden Zeichnung näher erläutert werden. Es zeigen:
- Fig. 1: Beispiel einer Anordnung mit einem EVG und einer Zugentlastungs-Vorrichtung in Explosionsdarstellung;
- Fig. 2: das in Fig. 1 gezeigte EVG in Seitenansicht;
- Fig. 3: das in Fig. 1 gezeigte EVG in perspektivischer Darstellung;
- Fig. 4: eine perspektivische Darstellung des EVG mit Zugentlastungs-Vorrichtung;
- Fig. 5: eine erfindungsgemäße Anordnung mit einem EVG und einer Zugentlastungs-Vorrichtung in Explosionsdarstellung und
- Fig. 6: eine Schnittdarstellung der bei der in Figur 5 an dem EVG angeordneten Zugentlastungs-Vorrichtung.

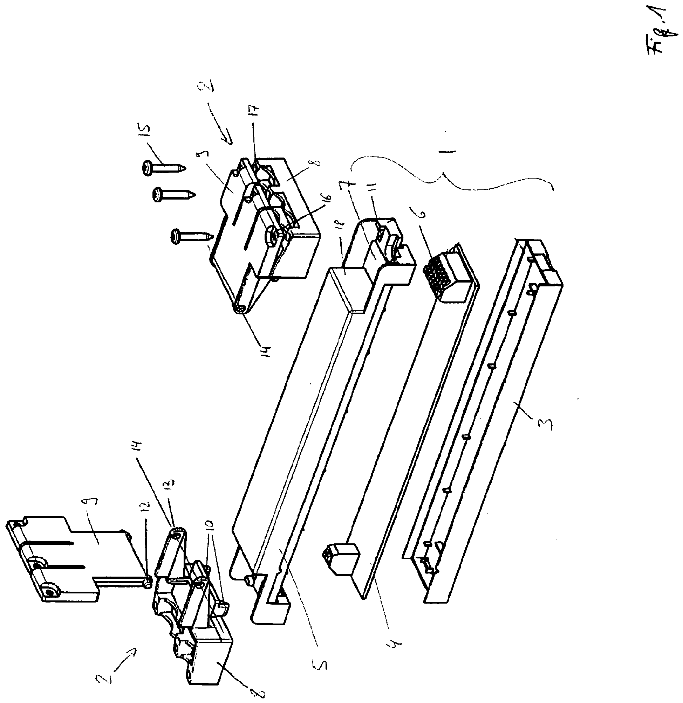

Fig. 1 zeigt ein Beispiel einer Anordnung mit einem elektronischen Vorschaltgerät (EVG) 1 zum Ansteuern einer Lichtquelle, das an jeder Stirnseite (18) mit einer Zugentlastungs-Vorrichtung 2 ausgestattet ist, in einer Explosionsdarstellung, um die vorliegende Erfindung näher zu erläutern. An dieser Stelle sei zunächst darauf hingewiesen, dass die Zugentlastungs-Vorrichtung 2 mit verschiedensten elektronischen Geräten kombiniert werden kann. Die hier dargestellten Beispiele zeigen jedoch beispielhaft ein EVG 1.

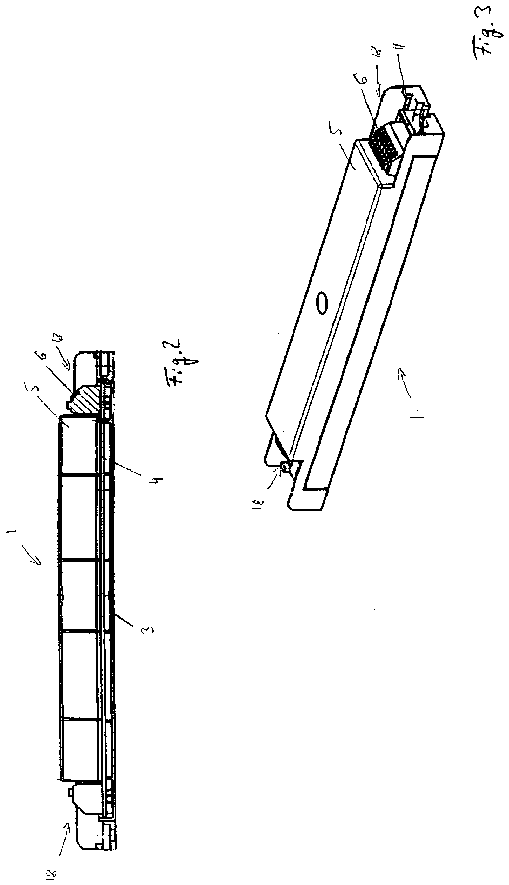

Das EVG 1 wird in den Fig. 2 und 3 in zusammengebauter Form dargestellt. Auf diesen Figuren ist die Zugentlastungs-Vorrichtung 2 nicht dargestellt. Fig. 2 zeigt das EVG 1 in Seitenansicht und Fig. 3 zeigt das EVG 1 in perspektivischer Darstellung.

Das EVG 1 weist eine Bodenplatte 3, eine Leiterplatine 4, die formschlüssig in die Bodenplatte 3 eingesetzt werden kann, sowie eine Abdeckung 5 auf. Die Bodenplatte 3 und die Abdeckung 5 weisen entsprechende Verbindungselemente auf, die es ermöglichen, die Bodenplatte 3 und die Abdeckung 5 derart miteinander zu verbinden, dass ein geschlossenes Gehäuse entsteht. Ferner ist auf der Leiterplatine 4 eine Anschlussklemme 6 angeordnet, die es erlaubt, einen Draht an das EVG 1 festzuklemmen. Die Abdeckung 5 weist eine Ausnehmung 7 auf, aus der die Anschlussklemme 6 bei einem zusammengebauten EVG herausragt.

Das EVG 1 ist üblicherweise mit weiteren Elementen, wie der Lichtquelle selbst oder einer Stromversorgungs-Vorrichtung durch Kabel verbunden. Ein solches Kabel besteht aus mindestens einem Draht sowie einer Ummantelung.

Ziel ist es nunmehr, das Kabel in zugentlasteter Weise mit dem EVG zu verbinden. Mit Hilfe einer Zugentlastung wird die Verbindung zwischen Kabeln und dem Endstück gegen mechanische Beanspruchung geschützt. Zu diesem Zweck wird das EVG 1 an seinen Stirnseiten 18 mit den Zugentlastungs-Vorrichtungen 2 verbunden.

Die Zugentlastungs-Vorrichtungen 2 bestehen jeweils aus einem Basisteil 8 und einem Deckel 9, welche das mindestens eine Kabel klemmend fixieren. Das Basisteil 8 weist ferner Vorsprünge 10 auf, welche zum Eingreifen in entsprechende Ausnehmungen 11 an dem Gehäuse des EVGs 1 ausgebildet sind, so dass die Zugentlastungs-Vorrichtung 2 mit dem EVG 1 formschlüssig verbunden werden kann.

Die Zugentlastungs-Vorrichtung 2 kann mit dem EVG 1 alternativ auch durch Rastelemente verbunden werden. Eine weitere Möglichkeit ergibt sich dadurch, dass die Vorsprünge 10 an dem EVG angebracht sind und die Zugentlastungs-Vorrichtung 2 entsprechende Ausnehmungen 11 aufweist, die eine Befestigung ermöglichen.

Die hier genannten Verbindungsarten der Zugentlastungs-Vorrichtung 2 mit dem EVG 1 ermöglichen stets eine besonders einfache, insbesondere werkzeuglose Montage der Zugentlastungs-Vorrichtung 2 an dem EVG 1.

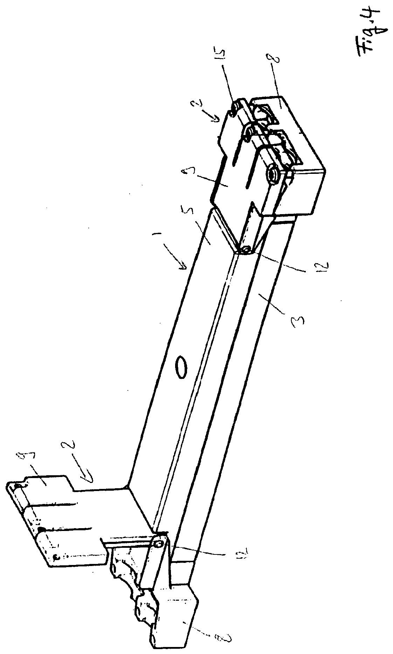

Der Deckel 9 ist ferner schwenkbar mit dem Basisteil 8 verbunden, wobei der Deckel 9 Vorsprünge 12 aufweist, die in entsprechende Ausnehmungen 13 am Basisteil eingesteckt werden können. Bei der in Fig. 1 oder Fig. 4 an der linken Stirnseite 18 des EVGs 1 angeordnete Zugentlastungs-Vorrichtung 2 sind der Deckel 9 und das Basisteil 8 nicht miteinander verbunden. An der rechten Stirnseite 18 ist eine Zugentlastungs-Vorrichtung 2 zu sehen, bei der der Deckel 9 auf dem Basisteil 8 geschlossen ist.

Durch die Vorsprünge 12 und die entsprechenden Ausnehmungen 13 wird eine Schwenkachse 14 für den Deckel definiert. Befindet sich der Deckel 9 in der geschlossenen Position, so kann er an dem Basisteil 8 arretiert werden. Zu diesem Zweck ist es insbesondere vorteilhaft, wenn der Deckel 9 mit dem Basisteil 8 mittels Schrauben 15 verschraubbar ist. Ferner weist der Deckel 9 Vertiefungen 16 auf, in die die vorzugsweise selbstschneidenden Schrauben eingesetzt werden können.

Wird nun ein Kabel an das in Fig. 1 gezeigte EVG 1 angeschlossen, so wird in einem ersten Schritt die Arretierung zwischen Deckel 9 und Basisteil 8 der Zugentlastungs-Vorrichtung 2 gelöst und der Deckel 9 wird hochgeklappt. Im nächsten Schritt wird das Kabel durch die geöffnete Zugentlastungs-Vorrichtung 2 eingeschoben und an seinen Enden mit der Anschlussklemme 6 verbunden. Durch diesen Schritt ist die elektrische Verbindung hergestellt. In einem abschließenden Schritt wird der Deckel 9 wieder heruntergeklappt und mit dem Basisteil 8 verschraubt. Die Zugentlastungs-Vorrichtung 2 ist nunmehr geschlossen und die Verbindung des Kabels mit dem EVG 1 kann durch Ziehen an dem Kabel nicht mehr gelöst werden. Dementsprechend ist diese Verbindung vor mechanischen Belastungen geschützt.

Bei der hier beschriebenen Zugentlastungs-Vorrichtung 2 wird das Kabel somit zwischen einem Deckel 9 und einem Basisteil 8 eingeklemmt. Diese Art der Zugentlastung weist den Vorteil auf, dass die Vorrichtung in der Lage ist, Kabel mit verschiedenen Querschnitten aufzunehmen. Im Falle eines EVGs 1 handelt es sich bei den Kabeln insbesondere um drei zweipolige Kabel mit einem Kabelquerschnitt von 0,5 bis 1,5 mm² oder um zwei fünfpolige Kabel mit einem Kabelquerschnitt von 0,5 bis 1,5 mm². Da der Abstand von Deckel 9 und Basisteil 8 mittels der Schrauben 15 leicht variiert werden kann, ist die Vorrichtung hinreichend flexibel bezüglich der Anzahl und dem Querschnitt der Kabel.

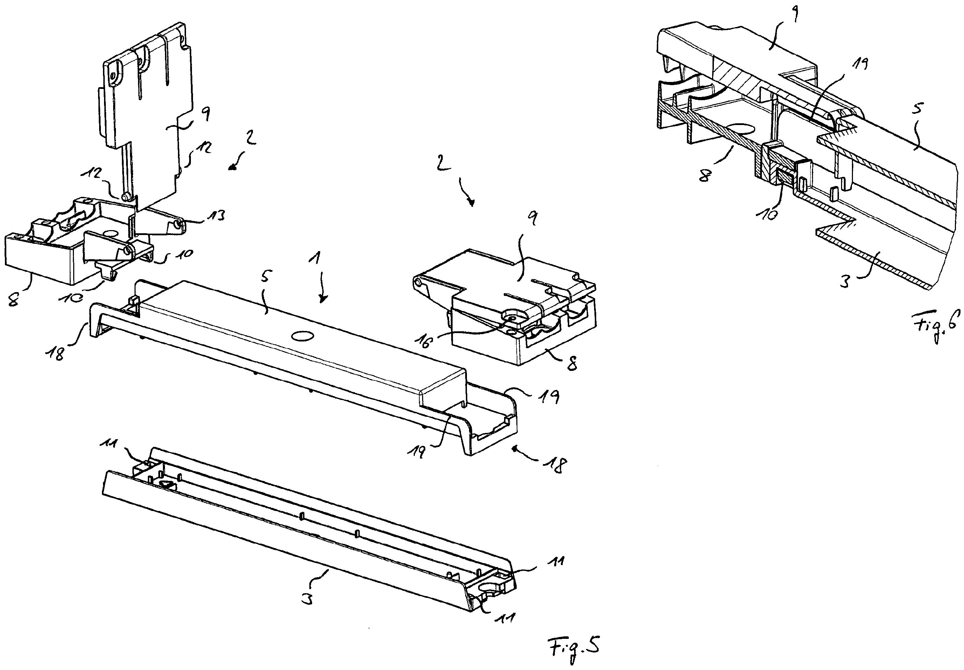

Anzumerken ist, dass bei dem bisherigen Beispiel die Zugentlastungs-Vorrichtung 2 an einem EVG geordnet wurde, welches aus zwei Gehäuseteilen besteht, die werkzeuglos voneinander getrennt werden können. Ein derartiges Gehäuse darf entsprechend den einschlägigen Normen lediglich innerhalb eines geschlossenen Leuchtengehäuses angeordnet werden. Auf der anderen Seite kommen allerdings oftmals auch sogenannte EVG-Deckeneinwurfgehäuse zum Einsatz, welche nicht innerhalb eines geschlossenen Leuchtengehäuses sondern beispielsweise in einem Raum oberhalb einer abgehängten Decke angeordnet werden. Hier ist vorgeschrieben, dass das Gehäuse des EVGs nicht versehentlich geöffnet werden darf, sodass dass Sorge dafür getragen werden muss, dass die Gehäuseteile nicht ohne Weiteres von einander gelöst werden können. Die Figuren 5 und 6 zeigen nunmehr eine erfindungsgemäße Anordnung, welche insbesondere in solchen Situationen zu besonderen Vorteilen führt.

Figur 5 zeigt zunächst die Explosionsdarstellung einer erfindungsgemäße Anordnung mit einem EVG-Gehäuse und daran anzuordnenden Zugentlastungs-Vorrichtungen 2, wobei vergleichbare Elemente des EVGs 1 bzw. der Zugentlastungs-Vorrichtung 2 wiederum mit den gleichen Bezugszeichen versehen wurden. Das EVG-Gehäuse besteht dementsprechend wiederum aus einer Bodenplatte 3 und einer Abdeckung 5, welche zu dem vollständigen Gehäuse zusammen gesetzt werden, an dessen Stirnseiten 18 dann jeweils eine Zugentlastungs-Vorrichtung 2 aufgeschnappt wird. Im Vergleich zu dem Beispiel der Figuren 1 bis 4 ist nunmehr allerdings vorgesehen, dass die Ausnehmungen 11 zum Einschnappen der Vorsprünge 10 der Zugentlastungs-Vorrichtung 2 an der Bodenplatte 3 des EVG-Gehäuses ausgebildet sind. Wird nunmehr also die Zugentlastungs-Vorrichtung auf das zusammengefügte EVG-Gehäuse aufgeschnappt, so wird diese entsprechend der Darstellung von Figur 6 mit der Bodenplatte 3 verrastet. Die Verrastung ist dabei vorzugsweise derart, dass diese nicht von Hand sondern lediglich mit Hilfe eines Werkzeugs, beispielsweise eines Schraubenziehers gelöst werden kann.

Wie der Schnittdarstellung von Figur 6 ferner entnommen werden kann, gelangt im aufgeschnappten Zustand ferner der den Vorsprüngen 12 zugewandte Bereich des Deckels 9 der Zugentlastungs-Vorrichtung 2 in Anlage gegen stirnseitige Wände 19 der Abdeckung 5 des EVG-Gehäuses. Mit anderen Worten, die mit der Bodenplatte 3 verrastete Zugentlastungs-Vorrichtung blockiert gleichzeitig auch die Abdeckung 5 des EVG-Gehäuses, sodass ein Öffnen des Gehäuses bzw. ein Lösen der Abdeckung 5 von der Bodenplatte 3 nicht mehr möglich ist. Erst nachdem die Zugentlastungs-Vorrichtung 2 unter Zuhilfenahme eines Werkzeugs entfernt wurde, kann das EVG-Gehäuse wiederum geöffnet werden, sodass die oben angesprochenen Normen zuverlässig eingehalten werden können. Hier erfüllt also die Zugentlastungs-Vorrichtung neben ihrer eigentlichen Aufgabe, nämlich die an das elektronische Gerät angeschlossenen Kabel zu ziehen, eine weitere Funktion.

Der Vorteil der Zugentlastungs-Vorrichtung 2 besteht nun auch darin, dass diese Zugentlastungs-Vorrichtung 2 unabhängig von der genauen Ausgestaltung des EVGs 1 oder auch eines anderen elektronischen Geräts eingesetzt werden kann. Das elektronische Gerät muss lediglich an einer Stirnseite 18 entsprechende Befestigungselemente aufweisen, die es erlauben die Zugentlastungs-Vorrichtung 2 zu befestigen. Dementsprechend kann die Zugentlastungs-Vorrichtung 2 universell für fast jedes beliebige elektronische Gerät verwendet werden. Eine Abhängigkeit von der Dimension des elektronischen Geräts besteht nicht mehr.

## Patentansprüche

1. Anordnung bestehend aus einem elektronischen Gerät (1) sowie mindestens einer mit dem elektronischen Gerät (1) gekoppelten Zugentlastungs-Vorrichtung (2) zur Zugentlastung von an dem elektronischen Gerät (1) angeschlossenen Kabeln, wobei die Zugentlastungs-Vorrichtung (2) Mittel (8, 9) zur Aufnahme und klemmenden Halterung mindestens eines Kabels aufweist und dazu ausgebildet ist, lösbar mit einer Stirnseite (18) des Gehäuses (3, 5) des elektronischen Geräts (1) gekoppelt zu werden,
**dadurch gekennzeichnet,**
**dass** das Gehäuse des elektronischen Geräts (1) aus zumindest zwei miteinander zu verbindenden Gehäuseteilen (3, 5) besteht, wobei die Zugentlastungs-Vorrichtung (2) im an dem elektronischen Gerät (1) befestigten Zustand die beiden Gehäuseteile (3, 5) aneinander arretiert.

2. Anordnung nach Anspruch 1,
**dadurch gekennzeichnet,**
**dass** an der Zugentlastungs-Vorrichtung (2) Vorsprünge (10) bzw. Rastelemente und/oder Ausnehmungen vorgesehen sind, welche zum Eingreifen in entsprechende Ausnehmungen (11) an dem Gehäuse (3, 5) des elektronischen Geräts (1) bzw. zum formschlüssigen Verbinden mit Vorsprüngen des Gehäuses (3, 5) ausgebildet sind.

3. Anordnung nach Anspruch 1 oder 2,
**dadurch gekennzeichnet,**
**dass** die Zugentlastungs-Vorrichtung (2) aus einem Basisteil (8) und einem Deckel (9) besteht, welche das mindestens eine Kabel klemmend fixieren.

4. Anordnung nach Anspruch 3,
**dadurch gekennzeichnet,**
**dass** der Deckel (9) mit dem Basisteil (8) in einer Klemmstellung arretierbar, insbesondere verschraubbar ist.

5. Anordnung nach Anspruch 3 oder 4,
**dadurch gekennzeichnet,**
**dass** der Deckel (9) schwenkbar mit dem Basisteil (8) verbunden ist.

6. Anordnung nach einem der vorherigen Ansprüche,
**dadurch gekennzeichnet,**
**dass** die Kopplung der Zugentlastungs-Vorrichtung (2) mit dem elektronischen Gerät (1) nur mit Hilfe eines Werkzeugs lösbar ist.

7. Anordnung nach einem der vorherigen Ansprüche,
**dadurch gekennzeichnet,**
**dass** es sich bei dem elektronischen Gerät (1) um ein elektronisches Vorschaltgerät handelt.

## Claims

1. An arrangement consisting of an electronic device (1) as well as at least one apparatus for strain relief (2) coupled with the electronic device (1) for the relief of strain on cables connected to an electronic device (1), wherein the apparatus for strain relief (2) has means (8, 9) for accommodating and for clamped holding of at least one cable and is designed to be coupled in a detachable manner to one front side (18) of the housing (3, 5) of the electronic device (1),
**characterized in**
**that** the housing of the electronic device (1) consists of at least two housing parts (3, 5) to be connected with each other, wherein the apparatus for strain relief (2) in the state fastened to the electronic device (1) locks the two housing parts (3, 5) together.

2. An arrangement according to Claim 1,
**characterized in**
**that** on the apparatus for strain relief (2) projections (10) or lock elements and/or recesses are provided, which are designed for engagement in corresponding recesses (11) on the housing (3, 5) of the electronic device (1) or for positively-locking connection with the projections of the housing (3, 5).

3. An arrangement according to Claim 1 or 2,
**characterized in**
**that** the apparatus for strain relief (2) consists of a base part (8) and a lid (9), which in a clamping manner secure the at least one cable.

4. An arrangement according to Claim 3,
**characterized in**
**that** the lid (9) is lockable, in particular, screwable, with the base part (8) in a clamping position.

5. An arrangement according to Claim 3 or 4,
**characterized in**
**that** the lid (9) is pivotably connected with the base part (8).

6. An arrangement according to any one of the preceding claims,
**characterized in**
**that** the coupling of the apparatus for strain relief (2) with the electronic device (1) is detachable only by means of a tool.

7. An arrangement according to any one of the preceding claims,
**characterized in**
**that** the electronic device (1) is an electronic ballast.

## Revendications

1. Arrangement constituée d'un appareil électronique (1) ainsi que d'au moins un dispositif de décharge de traction (2), couplé avec l'appareil électronique (1), pour la décharge de traction de câbles connectés à l'appareil électronique (1), le dispositif de décharge de traction (2) comprenant des moyens (8, 9) pour le logement et le maintien par serrage d'au moins un câble et étant conçu pour être couplé de manière amovible avec une face frontale (18) du boîtier (3, 5) de l'appareil électronique (1),
**caractérisé en ce que**
le boîtier de l'appareil électronique (1) est constitué d'au moins deux parties de boîtier (3, 5) à relier entre elles, le dispositif de décharge de traction (2) bloquant les deux parties de boîtier (3, 5) entre elles, dans l'état fixé à l'appareil électronique (1).

2. Arrangement selon la revendication 1,
**caractérisé en ce que**
sur le dispositif de décharge de traction (2) sont prévues des saillies (10) ou des éléments d'encliquetage et/ou des évidements, qui sont conçus pour s'emboîter dans des évidements correspondants (11) sur le boîtier (3, 5) de l'appareil électronique (1) ou pour la liaison par complémentarité de forme avec des saillies du boîtier (3, 5).

3. Arrangement selon la revendication 1 ou 2,
**caractérisé en ce que**
le dispositif de décharge de traction (2) est constitué d'une partie de base (8) et d'un couvercle (9) qui fixent l'au moins un câble par serrage.

4. Arrangement selon la revendication 3,
**caractérisé en ce que**
le couvercle (9) peut être bloqué, plus particulièrement vissé, avec la partie de base (8) dans une position de serrage.

5. Arrangement selon la revendication 3 ou 4,
**caractérisé en ce que**
le couvercle (9) est relié de manière pivotante avec la partie de base (8).

6. Arrangement selon l'une des revendications précédentes,
**caractérisé en ce que**
le couplage du dispositif de décharge de traction (2) avec l'appareil électronique (1) ne peut être libéré qu'à l'aide d'un outil.

7. Arrangement selon l'une des revendications précédentes,
**caractérisé en ce que**
l'appareil électronique (1) est un ballast électronique.
